# EUROPÄISCHE PATENTSCHRIFT

(11) **EP 1 258 780 B1**
(45) Veröffentlichungstag und Bekanntmachung des Hinweises auf die Patenterteilung: **16.11.2005**
(21) Anmeldenummer: 02008789.6
(22) Anmeldetag: 19.04.2002
(51) Int. Cl.: G03F 7/20

(54) **Optisches Abbildungssystem mit Polarisationsmitteln**
Optical imaging system with polarising means
Système optique de formation d'image avec moyens de polarisation

(30) Priorität: 15.05.2001 DE 10124566
(43) Veröffentlichungstag der Anmeldung: 20.11.2002
(73) Patentinhaber: Carl Zeiss SMT AG, 73447 Oberkochen (DE)
(72) Erfinder: Gerhard, Michael, Dr., 73432 Aalen (DE)
(74) Vertreter: Patentanwälte Ruff, Wilhelm, Beier, Dauster & Partner

(56) Entgegenhaltungen:
- DE-A- 19 535 392
- US-A- 3 484 714

## Beschreibung

Die Erfindung bezieht sich auf ein optisches Abbildungssystem mit mehreren entlang einer optischen Achse hintereinander angeordneten, abbildungsfunktionellen optischen Komponenten und im Bereich bis vor der letzten abbildungsfunktionellen optischen Komponente angeordneten Radialpolarisationserzeugungsmitteln.

In der Offenlegungsschrift DE 195 35 392 A1 ist ein derartiges optisches Abbildungssystem in Form einer Mikrolithographie-Projektionsbelichtungsanlage mit z.B. einer i-Linien-Quecksilberentladungslampe als Lichtquelle offenbart. Durch die radiale Polarisation des zur Waferbelichtung verwendeten Lichts soll die Einkopplung des Lichts in die Resistschicht speziell bei sehr hohen Einfallswinkeln verbessert werden, bei gleichzeitig maximaler Unterdrückung von stehenden Wellen, die durch Reflexionen an den beiden Grenzschichten des Resists verursacht werden können. Für die Radialpolarisationserzeugungsmittel werden verschiedene Radialpolarisationselemente unter Verwendung von doppelbrechendem Material angegeben. Das jeweilige Radialpolarisationselement wird im Bereich nach der letzten phasenkorrigierenden oder polarisierenden optischen Komponente angeordnet, damit sich der Grad an erreichter radialer Polarisation vor dem Auftreffen auf den Wafer nicht mehr ändert. Wenn für das Projektionsobjektiv eine katadioptrische Optik verwendet wird, ist das Radialpolarisationselement z.B. bevorzugt hinter dessen letztem Umlenkspiegel angeordnet. Ansonsten kann es z.B. schon im vorgeschalteten Beleuchtungssystem angeordnet sein.

Radial polarisiertes Licht, d.h. solches, das linear und parallel zur Ebene des Einfalls auf eine Grenzfläche polarisiert ist, ist im allgemeinen für die Abbildungsoptik z.B. von Mikrolithographie-Projektionsbelichtungssystemen bevorzugt, da für derart polarisiertes Licht eine besonders effektive Entspiegelung der abbildungsfunktionellen optischen Komponenten, insbesondere der Linsen, durch eine entsprechende Beschichtung möglich ist, was speziell bei hoher numerischer Apertur und kleinen Wellenlängen z.B. im UV-Bereich von Bedeutung ist, da es für diesen Bereich nur wenig geeignete Beschichtungsmaterialien gibt. Andererseits sollte zur Erzeugung eines größtmöglichen Abbildungs-Interferenzkontrastes für die Bildgebung z.B. auf einem Wafer möglichst tangential polarisiertes Licht auf den Wafer einfallen. Hierbei handelt es sich um Strahlung, die linear und senkrecht zur Ebene des Einfalls eines abbildenden Strahlungsbündels auf eine jeweilige Grenzfläche einer Linse oder dergleichen polarisiert ist. Um dies zu erreichen, wird in der älteren deutschen Patentanmeldung 100 10 131.3 die Verwendung eines Tangentialpolarisationselementes anstelle des Radialpolarisationselementes der DE 195 35 392 A1 vorgeschlagen, das in der Umgebung der Pupillenebene des Projektionsobjektivs oder auch schon im vorgeschalteten Beleuchtungssystem angeordnet und aus segmentierten doppelbrechenden Platten aufgebaut sein kann. Die deutsche Patentanmeldung 100 10 131.3 wurde als DE 100 10 131 A1 veröffentlicht und gehört nicht zum Stand der Technik gemäß Artikel 54 EPÜ. Die entsprechende veröffentlichte europäische Patentanmeldung EP 1 130 470 A2 gehört zum Stand der Technik gemäß Artikel 54(3)(4) EPÜ.

Aus der Patentschrift US 3.484.714 ist es bekannt, zwischen zwei Laserstäben ein optisch aktives Polarisationsdrehelement zur Bewirkung einer Polarisationsdrehung um 90° anzuordnen. Das Polarisationsdrehelement kann durch einen senkrecht zu seiner optischen Achse geschnittenen Abschnitt eines Quarzkristalls gebildet sein. Für die betreffende Quarzkristallplatte wird für den Fall einer Laserwellenlänge von 1,06µm eine Dicke von 4,2mm und für den Fall einer Laserwellenlänge von 0,694µm eine Dicke von 5,92mm vorgeschlagen.

Der Erfindung liegt als technisches Problem die Bereitstellung eines optischen Abbildungssystems der eingangs genannten Art zugrunde, das einerseits eine vergleichsweise gute Entspiegelung seiner Optik ermöglicht, was störendes reflektiertes Streulicht minimiert, und andererseits in der Lage ist, ausgangsseitig ein Lichtbündel abzugeben, mit dem sich ein hoher bildgebender Interferenzkontrast erzeugen lässt.

Die Erfindung löst dieses Problem durch die Bereitstellung eines optischen Abbildungssystems mit den Merkmalen des Anspruchs 1.

Das erfindungsgemäße Abbildungssystem zeichnet sich dadurch aus, dass zum einen durch entsprechende Radialpolarisationserzeugungsmittel radial polarisiertes Licht bereitgestellt wird, mit dem wenigstens ein Teil der abbildungsfunktionellen optischen Komponenten arbeitet, und zum anderen ein Polarisationsdrehelement zur Drehung der radialen Polarisation in tangentiale Polarisation vorgesehen ist, um in einer Bildebene tangential polarisiertes Licht bereitzustellen, wobei das Polarisationsdrehelement hinter mindestens einer, vorzugsweise mehreren bis hin zu allen abbildungsfunktionellen optischen Komponenten des Systems angeordnet ist.

Diese erfindungsgemäße Maßnahme hat zur Folge, dass alle zwischen den Radialpolarisationserzeugungsmitteln und dem Polarisationsdrehelement liegenden abbildungsfunktionellen optischen Komponenten mit radial polarisiertem Licht arbeiten können, für das sie sehr effektiv entspiegelt werden können. Als Radialpolarisationserzeugungsmittel kann insbesondere ein Radialpolarisationselement herkömmlicher Art dienen, das an beliebiger Stelle des Strahlengangs im Bereich zwischen der Lichtquelle, d.h. vor der ersten abbildungsfunktionellen optischen Komponente, und der letzten abbildungsfunktionellen optischen Komponente angeordnet sein kann, jedoch vor dem Polarisationsdrehelement. Gleichzeitig bewirkt das Polarisationsdrehelement eine Umwandlung des für die abbildungsfunktionellen optischen Komponenten wünschenswerten, radial polarisierten Lichtes in tangential polarisiertes Licht, das dann auf die Bildebene einfällt und dort die Erzeugung eines hohen Interferenzkontrastes ermöglicht. Da diese Polarisationsumwandlung durch Polarisationsdrehung erfolgt, lässt sich der damit verbundene Lichtverlust minimal halten.

In vorteilhaften Weiterbildungen der Erfindung, in der das optische Abbildungssystem ein Mikrolithographie-Projektionsbelichtungssystem ist, ist das Polarisationsdrehelement zur Drehung des zuvor radial polarisierten Lichts in tangential polarisiertes Licht in einem Bereich des Projektionsobjektivs mit zur optischen Achse weitgehend parallelem Strahlengang, insbesondere einer Pupillenebene, oder im Bereich zwischen einer Pupillenebene und einer Bildebene angeordnet, in der z.B. ein zu belichtender Wafer liegt. Die erstgenannte Anordnung der Pupillenebene hat den Vorteil, dass durch weitgehend senkrechten Einfall des Lichts auf das Polarisationsdrehelement eine hohe optische Aktivität gegeben ist und Schrägbeleuchtungseffekte, wie Doppelbrechungseffekte, minimal bleiben. Anderseits hat eine Anordnung des Polarisationsdrehelements näher in Richtung Bildebene den Vorteil, dass auch noch die zwischen der Pupillenebene und dem Polarisationsdrehelement liegenden abbildungsfunktionellen optischen Komponenten von radial polarisiertem Licht durchstrahlt werden können und eine geringere Abmessung für das Polarisationsdrehelement genügt.

In einer Weiterbildung der Erfindung wird als Polarisationsdrehelement eine Platte mit einem optisch aktiven Material verwendet. Optisch aktive Materialien haben bekanntlich die Eigenschaft, die Polarisation von transmittiertem Licht zu drehen, wobei der Drehwinkel proportional zur Materialdicke ist und die Proportionalitätskonstante mit kleiner werdender Wellenlänge zunimmt. In einer weiteren Ausgestaltung der Erfindung dient eine Quarzkristallplatteals Polarisationsdrehelement. Zwar hat kristallines Quarz auch doppelbrechende Eigenschaften, durch geeignete Dimensionierung und Orientierung der Quarzplatte können diese jedoch jedenfalls für UV-Licht z.B. im Wellenlängenbereich um 157nm oder darunter so klein gehalten werden, dass sie die vorliegend erwünschte Polarisationsdrehung durch die optische Aktivität des Quarzmaterials nicht signifikant stören.

In einer vorteilhaften Ausgestaltung der Erfindung weist die Kristallachse der Quarzkristallplatte im wesentlichen in Richtung der Plattennormalen. Die so ausgelegte Quarzkristallplatte eignet sich besonders gut zur Verwendung als Polarisationsdrehelement im erfindungsgemäßen optischen Abbildungssystem.

In einer Weiterbildung der Erfindung beträgt die Dicke der Quarzkristallplatte höchstens 500µm, vorzugsweise liegt die Dicke bei ca. 200µm oder weniger. Platten mit dieser geringen Dicke eignen sich besonders zur Erfüllung der Polarisationsdrehfunktion im erfindungsgemäßen optischen Abbildungssystem, wenn letzteres mit UV-Strahlung niedriger Wellenlänge von 157µm oder weniger arbeitet.

Eine vorteilhafte Ausführungsform der Erfindung ist in den Zeichnungen dargestellt und wird nachfolgend beschrieben. Hierbei zeigen:
- Fig. 1: eine schematische Darstellung eines Mikrolithographie-Projektionsbelichtungssystems mit einem Radialpolarisationselement für radiale Polarisation im Beleuchtungssystem und einem Polarisationsdrehelement zur Polarisationsdrehung auf tangentiale Polarisation im Projektionsobjektiv und
- Fig. 2: eine detailliertere schematische Darstellung des Projektionsobjektivs von Fig. 1.

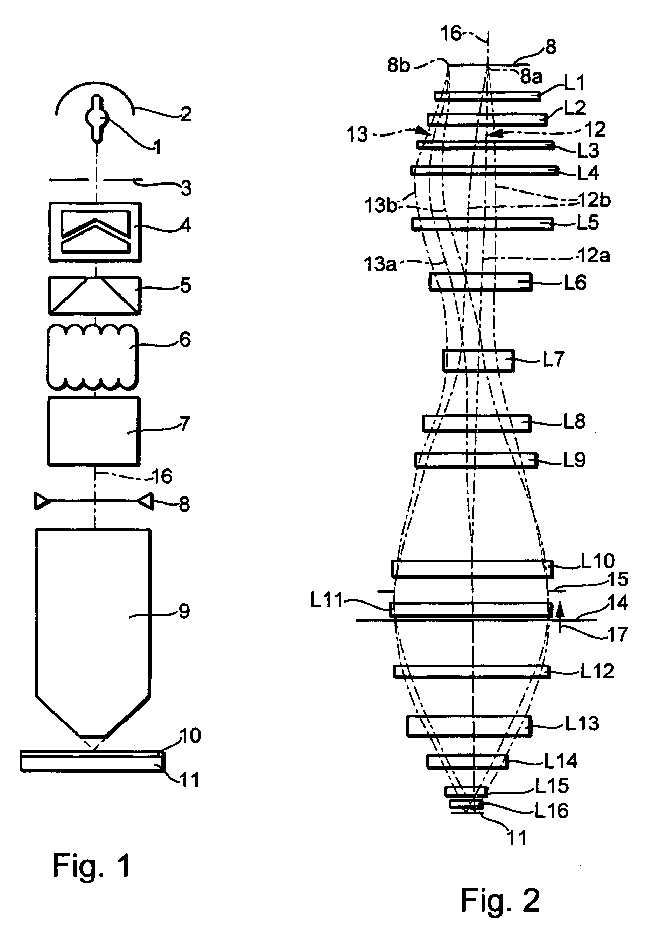

Fig. 1 veranschaulicht ein bis auf die Anordnung eines Polarisationsdrehelementes im Projektionsobjektiv herkömmliches Mikrolithographie-Projektionsbelichtungssystem, wie es in der oben zitierten DE 195 35 392 A1 beschrieben ist. Eine Lichtquelle 1, die UV-Belichtungsstrahlung mit gewünschter Wellenlänge erzeugt, z.B. eine i-Linien-Quecksilberentladungslampe, beleuchtet mittels eines Spiegels 2 eine Blende 3, der ein Objektiv 4 folgt, bei dem es sich insbesondere um ein ZoomObjektiv handeln kann und das verschiedene Einstellungen ermöglicht, insbesondere die Wahl einer gewünschten Ringapertur. Alternativ zu einer Quecksilberentladungslampe kann als Lichtquelle 1 eine Laserlichtquelle verwendet werden, die Licht mit einer Wellenlänge von ca. 260nm oder weniger, z.B. mit einer Wellenlänge von 157nm, abstrahlt. In diesem Fall kann dann auch der Spiegel 2 entfallen.

Hinter dem Objektiv 4 ist ein Radialpolarisationselement 5 angeordnet, das unpolarisiert eintretendes Licht in radial polarisiertes Licht umwandelt. Das Radialpolarisationselement 5 kann z.B. als Kegelstumpfpolarisator mit einem in der DE 195 35 392 A1 beschriebenen Aufbau realisiert sein, der diese Polarisationsumwandlung ohne signifikanten Lichtverlust leistet. Das somit weitestgehend radial polarisierte Licht gelangt dann vom Radialpolarisationselement 5 zu einem Wabenkondensor 6 und einer anschließenden Relais- und Feldoptik 7. Diese Teile dienen zusammen der optimierten Beleuchtung einer die abzubildende Struktur tragenden Maske 8, auch Retikel genannt. Ein anschließendes, als Reduktionsobjektiv ausgelegtes Projektionsobjektiv 9 bildet die Maskenstruktur, die sich in der Gegenstandsebene des Projektionsobjektivs 9 befindet, mit höchster Auflösung von vorzugsweise unter 1µm verkleinert auf einen in der Bildebene des Projektionsobjektivs 9 liegenden Resistfilm 10 eines Wafers 11 ab. Die numerische Apertur des Systems liegt vorzugsweise über 0,5, insbesondere zwischen 0,7 und 0,9.

Fig. 2 zeigt schematisch einen möglichen Aufbau des Projektionsobjektivs 9 mit einer Vielzahl von Linsenelementen L1 bis L16. Da typischerweise in derartigen Projektionsobjektiven verwendete Linsenaufbauten vielfältig bekannt sind, sind die Linsenelemente L1 bis L16 in Fig. 2 nur stellvertretend für solche herkömmlichen Linsenaufbauten zu verstehen und auch nur durch symbolische Rechtecke repräsentiert, die selbstverständlich nicht die wahre geometrische Form der Linsenelemente L1 bis L14 wiedergeben. Zur Veranschaulichung der Projektionsobjektivfunktion sind in Fig. 2 für einen zentralen Maskenpunkt 8a und einen seitlichen Maskenpunkt 8b der schematische Verlauf je eines Hauptlichtstrahls 12a, 13a und der beiden Randstrahlen 12b, 13b der zwei zugehörigen Abbildungslichtbündel 12, 13 dargestellt.

Das Charakteristikum des Projektionsobjektivs gemäß Fig. 2 ist im Anordnen eines Polarisationsdrehelementes 14 zu sehen, das sich im gezeigten Beispiel kurz hinter einer Pupillenebene 15 des Projektionsobjektivs befindet, in der eine übliche Aperturblende angeordnet ist. Das Polarisationsdrehelement 14 ist dafür ausgelegt, das eintrittsseitig radial polarisierte Licht in tangential polarisiertes Licht zu drehen. Für diesen Zweck ist beispielsweise eine dünne kristalline Quarzplatte verwendbar, die mit ihrer in Fig. 2 schematisch angedeuteten Kristallachse 17 in wesentlichen parallel zur optischen Achse des Projektionsobjektivs eingebaut wird, wobei die Kristallachse 17 der Quarzkristallplatte 14 im wesentlichen senkrecht zur Plattenebene, d.h. parallel zur Plattennormalen verläuft.

Kristallines Quarzmaterial ist bekanntlich optisch aktiv, und aufgrund seiner optischen Aktivität dreht es die Polarisationsrichtung der einfallenden Strahlung im Gegensatz zur normalen Doppelbrechung unabhängig von deren Richtung. Ein weiterer Vorteil optisch aktiver Materialien besteht darin, dass sie keine Doppelbilder erzeugen. Der Drehwinkel ist bei gegebenem Material proportional zur Materialdicke, wobei die Proportionalitätskonstante temperatur- und vor allem wellenlängenabhängig ist. Für die vorliegende Anwendung ist dabei besonders günstig, dass diese Proportionalitätskonstante mit kleiner werdender Wellenlänge stark zunimmt und z.B. für den UV-Bereich zwischen etwa 150nm und 260nm um eine Vielfaches höher als im Bereich sichtbaren Lichtes ist. Aus diesem Grund genügt für die gewünschte Drehung bei Einsatz von UV-Strahlung im Mikrolithographie-Projektionsbelichtungssystem schon eine sehr geringe Dicke der Quarzplatte 14 von nur ca. 500µm oder weniger, vorzugsweise 200µm oder darunter. Da gleichzeitig die Doppelbrechungseffekte mit kleiner werdender Wellenlänge nicht signifikant zunehmen, verbessert sich dementsprechend für kleine Wellenlängen im UV-Bereich das Verhältnis der vorliegend gewünschten optischen Aktivitätsfunktion zu eventuell störenden Doppelbrechungseffekten deutlich.

Ein Anordnen des Polarisationsdrehelementes 14 in der Nähe der Pupillenebene 15 oder einer anderen Stelle des Lichtstrahlengangs, an der die Lichtstrahlen parallel oder unter einem nur geringen Schrägwinkel zur optischen Achse 16 verlaufen, hat den Vorteil eines weitgehend senkrechten Lichteinfalls, unter dem das Verhältnis von optischer Aktivität zu den hier nicht gewünschten Doppelbrechungseffekten von kristallinem Quarz besonders hoch ist. Bei der in Fig. 2 gezeigten Lage des Polarisationsdrehelementes 14 befinden sich immerhin bereits elf der sechzehn Linsen L1 bis L16 des Projektionsobjektivs sowie die gesamte Optik des Beleuchtungssystems ab dem Radialpolarisationselement 5 innerhalb des Strahlengangabschnitts, in welchem das Licht primär radial polarisiert ist, was für die Linsenentspiegelung besonders effektiv ist, während andererseits das Polarisationsdrehelement 14 für den gewünschten Einfall von primär tangential polarisiertem Licht auf den Wafer 11 sorgt.

Alternativ kann das Polarisationsdrehelement 14 auch an einer beliebigen anderen Stelle entlang der optischen Achse 16 des Systems positioniert sein, vorzugsweise möglichst nahe in Richtung Bildebene bzw. Wafer 11, um möglichst viele der abbildungsfunktionellen optischen Komponenten mit dem radial polarisierten Licht durchstrahlen zu können. Durch Verlagerung der Position des Polarisationsdrehelementes 14 vom Bereich der Pupillenebene 15 näher in Richtung Wafer 11 kann ein geringerer Durchmesser des Polarisationsdrehelementes 14 gewählt werden, und es kann wenigstens ein Teil der zwischen der gezeigten Position des Polarisationsdrehelements 14 und dem Wafer 11 liegenden Linsen L12 bis L16 noch von primär radial polarisiertem Licht durchstrahlt werden. Allerdings nimmt dann die Winkelbelastung zu, d.h. der zur optischen Achse 16 gemessene Schrägwinkel des Lichteinfalls auf das Polarisationsdrehelement 14.

Mit zunehmendem Schrägwinkel wird das Verhältnis zwischen der Stärke der optischen Aktivität und der Stärke der Doppelbrechung geringer, so dass der Einfluss von Doppelbrechungseffekten des kristallinen Quarzmaterials etwas größer wird. Anhand des jeweiligen Anwendungsfalls kann entschieden werden, welche Winkelbelastung noch akzeptabel ist. Dies hängt auch davon ab, wie gut das Licht vor Erreichen des Polarisationsdrehelementes 14 zur optischen Achse des Kristalls radial polarisiert ist. Denn im Idealfall von vollständig radial polarisiertem Licht tritt auch unter Winkelbelastung, d.h. bei Schrägbeleuchtung, keine Doppelbrechung auf. In der Praxis ist dieser Idealfall aber meist nicht ganz zu verwirklichen, weil zum einen schon das vom Beleuchtungssystem gelieferte Licht nicht exakt radial polarisiert ist und zum anderen eine gewisse Polarisationsdrehung aus der radialen Polarisation heraus aufgrund Spannungsdoppelbrechung der Linsen auftritt. Besonders für kleine UV-Wellenlängen kann wegen der dann sehr hohen optischen Aktivität durchaus eine merkliche Winkelbelastung zugelassen werden, bis hin zu der Maßnahme, das Polarisationsdrehelement 14 zwischen der letzten Linse L16 und dem Wafer 11 zu platzieren. Die letztgenannte Platzierung des Polarisationsdrehelementes 14 hat den besonderen Vorteil, das alle optischen Systemkomponenten mit radial polarisiertem Licht arbeiten können und das Polarisationsdrehelement 14 nicht in das Projektionsobjektiv eingebaut werden braucht, sondern außerhalb desselben angeordnet werden kann.

Die obige Beschreibung eines vorteilhaften Ausführungsbeispiels macht deutlich, dass sich mit dem erfindungsgemäßen optischen Abbildungssystem eine hohe Abbildungsqualität weitgehend ohne störende Streulichteinflüsse erzielen lässt, indem ein weit überwiegender Teil, vorzugsweise mindestens 2/3, der abbildungsfunktionellen optischen Komponenten von radial polarisiertem Licht durchstrahlt wird, für das diese optischen Komponenten sehr effektiv entspiegelt werden können. Zudem ist das System in der Lage, in der Bildebene ein weitestgehend polarisiertes Lichtbündel bereitzustellen, mit dem sich ein hoher Interferenzkontrast erzeugen lässt, wie er beispielsweise in Anwendung als Mikrolithographie-Projektionsbelichtungssystem zur Resistbelichtung eines Wafers von Vorteil ist.

## Patentansprüche

1. Optisches Abbildungssystem mit
- mehreren entlang einer optischen Achse (16) hintereinander angeordneten, abbildungsfunktionellen optischen Komponenten (4, 6, 7, L1 bis L16) und
- an einer vorgebbaren Stelle im Bereich bis vor der letzten abbildungsfunktionellen optischen Komponente (L16) angeordneten Radialpolarisationserzeugungsmitteln (5),
**gekennzeichnet durch**
- ein Polarisationsdrehelement (14) zur Drehung radialer Polarisation in tangentiale Polarisation, das an einer vorgebbaren Stelle im Bereich ab der auf die Radialpolarisationserzeugungsmittel (5) folgenden abbildungsfunktionellen optischen Komponente (6) angeordnet ist.

2. Optisches Abbildungssystem nach Anspruch 1, weiter **dadurch gekennzeichnet, dass** es ein Mikrolithographie-Projektionsbelichtungssystem bildet.

3. Optisches Abbildungssystem nach Anspruch 2, weiter **dadurch gekennzeichnet, dass** das Polarisationsdrehelement (14) in einem Bereich des Projektionsobjektivs des Mikrolithographie-Projektionsbelichtungssystems angeordnet ist, in welchem der Abbildungsstrahlengang im wesentlichen parallel zur optischen Achse (16) verläuft.

4. Optisches Abbildungssystem nach Anspruch 2, weiter **dadurch gekennzeichnet, dass** das Polarisationsdrehelement (14) im Bereich zwischen einer Pupillenebene (15) und einer Bildebene (10, 11) des Projektionsobjektivs des Mikrolithographie-Projektionsbelichtungssystems angeordnet ist.

5. Optisches Abbildungssystem nach einem der Ansprüche 1 bis 4, weiter **dadurch gekennzeichnet, dass** das Polarisationsdrehelement eine Platte (14) mit optisch aktivem Material beinhaltet.

6. Optisches Abbildungssystem nach Anspruch 5, weiter **dadurch gekennzeichnet, dass** die Platte (14) aus kristallinem Quarzmaterial gebildet ist, das mit seiner optischen Achse oder Kristallachse parallel zur optischen Achse (16) des Abbildungssystems angeordnet ist.

7. Optisches Abbildungssystem nach Anspruch 6, weiter **dadurch gekennzeichnet, dass** die Dicke der Platte (14) höchstens 500µm, vorzugsweise 200µm oder weniger, beträgt.

## Claims

1. Optical imaging system having
- a number of imaging-functional optical components (4, 6, 7, L1 to L16) arranged along an optical axis (16) one behind another, and
- means (5) for generating radial polarization which are arranged at a prescribable location in the region up to the last imaging-functional optical component (L16),
**characterized by**
- a polarization rotating element (14) for rotating radial polarization into tangential polarization, which is arranged at a prescribable location in the region starting from the imaging-functional optical component (6) following the means (5) for generating radial polarization.

2. Optical imaging system according to Claim 1, further **characterized in that** it forms a microlithography projection exposure system.

3. Optical imaging system according to Claim 2, further **characterized in that** the polarization rotating element (14) is arranged in a region of the projection objective of the microlithography projection exposure system in which the imaging beam path runs substantially parallel to the optical axis (16).

4. Optical imaging system according to Claim 2, further **characterized in that** the polarization rotating element (14) is arranged in the region between a pupil plane (15) and an image plane (10, 11) of the projection objective of the microlithography projection exposure system.

5. Optical imaging system according to one of Claims 1 to 4, further **characterized in that** the polarization rotating element includes a plate (14) with optically active material.

6. Optical imaging system according to Claim 5, further **characterized in that** the plate (14) is formed from crystalline quartz material which is arranged with its optical axis or crystal axis parallel to the optical axis (16) of the imaging system.

7. Optical imaging system according to Claim 6, further **characterized in that** the thickness of the plate (14) is at most 500 µm, preferably 200 µm or less.

## Revendications

1. Système de représentation optique comprenant
- plusieurs composants optiques à fonctionnalité de représentation (4, 6, 7, L1 à L16) disposés les une derrière les autres le long d'un axe optique (16) et
- des moyens de production de polarisation radiale (5) disposés en un endroit pouvant être prédéfini dans la zone qui s'étend jusque avant le dernier composant optique à fonctionnalité de représentation (L16),
**caractérisé par**
- un élément de rotation de la polarisation (14) destiné à faire tourner la polarisation radiale en polarisation tangentielle, lequel est disposé en un endroit pouvant être prédéfini dans la zone à partir du composant optique à fonctionnalité de représentation (6) succédant aux moyens de production de polarisation radiale (5).

2. Système de représentation optique selon la revendication 1, **caractérisé** aussi en ce qu'il forme un système d'éclairage de projection de microlithographie.

3. Système de représentation optique selon la revendication 2, **caractérisé** aussi en ce que l'élément de rotation de la polarisation (14) est disposé dans une zone de l'objectif de projection du système d'éclairage de projection de microlithographie dans laquelle le trajet du rayon de représentation passe essentiellement parallèlement à l'axe optique (16).

4. Système de représentation optique selon la revendication 2, **caractérisé** aussi en ce que l'élément de rotation de la polarisation (14) est disposé dans la zone entre un plan de pupille (15) et un plan d'image (10, 11) de l'objectif de projection du système d'éclairage de projection de microlithographie.

5. Système de représentation optique selon l'une des revendications 1 à 4, **caractérisé** aussi en ce que l'élément de rotation de la polarisation comprend une plaque (14) avec un matériau optiquement actif.

6. Système de représentation optique selon la revendication 5, **caractérisé** aussi en ce que la plaque (14) est constituée de quartz cristallin dont l'axe optique ou dont l'axe du cristal est disposé parallèlement à l'axe optique (16) du système de représentation.

7. Système de représentation optique selon la revendication 6, **caractérisé** aussi en ce que l'épaisseur de la plaque (14) est au maximum de 500 µm, de préférence de 200 µm ou moins.
